# EUROPEAN PATENT SPECIFICATION

(11) **EP 2 223 353 B1**
(45) Date of publication and mention of the grant of the patent: **21.02.2018**
(21) Application number: 08860229.7
(22) Date of filing: 08.12.2008
(51) Int. Cl.: H01L 33/46, H01L 33/00, H01L 33/50

(54) **SIDE-EMITTING, LIGHT EMITTING DEVICE WITH HYBRID, TOP SCATTERING-REFLECTOR**
SEITENEMITTIERENDE, LICHTEMITTIERENDE VORRICHTUNG MIT HYBRID-, TOP-SCATTERING-REFLEKTOR
DISPOSITIF ÉLECTROLUMINESCENT À ÉMISSION LATÉRALE AVEC RÉFLECTEUR DIFFUSIF SUPÉRIEUR HYBRIDE

(30) Priority: 11.12.2007 EP 07122848
(43) Date of publication of application: 01.09.2010
(73) Proprietor: Koninklijke Philips N.V., 5656 AE Eindhoven (NL)
(72) Inventor: JAGT, Hendrik, J., B., NL-5656 AE Eindhoven (NL)
(74) Representative: Rüber, Bernhard Jakob
(86) International application number: PCT/IB2008/055144
(87) International publication number: WO 2009/074944

(56) References cited:
- EP-A- 1 845 564
- WO-A-2007/004701
- US-A1- 2006 145 170
- US-A1- 2006 202 219
- US-A1- 2007 138 494
- US-B1- 6 630 691

## Description

### FIELD OF THE INVENTION

The present invention relates to a side-emitting light emitting device comprising at least one light emitting diode (LED) arranged on a substrate and facing a hybrid scattering reflector disposed at a distance from and extending along the extension of said substrate.

### BACKGROUND OF THE INVENTION

Top-emitting LEDs having various bottom, light-scattering reflectors are known in the art from e.g. EP 1 845 564 A2.

Hybrid reflective and patterned bottom electrodes for LEDs in flip-chip are known from e.g. WO 2007/004701 A1.

Hybrid reflectors consisting of a scattering layer and a reflective metal layer are known for LEDs from e.g. US 2006/0145170 A1. Colored LEDs as well as phosphor converted high power LEDs are attractive for use in large backlight panels as efficient high-brightness light sources. However, in certain applications, such as thin backlights for handheld display devices, such as mobile phones, PDAs and the like, it is desired to use thin side-emitting light emitting devices as light sources. Various side-emitting LED devices are described in US 2007/0138494 A1, Pugh et al. However, neither light-scattering nor surface-roughening is disclosed therein. A side-emitting light emitting device is described in US 2006/0208269 A1, Kim et al, which describes a light emitting diode arranged on a substrate and under a reflective surface, which is designed such that light from the light emitting diode is reflected towards the sides of the device by means of total internal reflection. Behind the reflective surface, on the opposite side from the LED, is arranged a scattering material in order to scatter and reflect back through the reflective surface light that has passed through the reflective surface, i.e. light not subject to total internal reflection on the reflective surface.

However, in order for the above device to work properly, the reflective surface must be slanted so that light coming from beneath is reflected to the sides by means of total internal reflection. Hence, the distance from the substrate to the reflecting surface must increase gradually towards the sides. This adds to the total thickness of the device. Further, in order to prevent light from leaving the scattering material through the top surface, the scattering material needs to have a substantial thickness, which also might add to the total thickness of the device.

Hence, there is a need in the art for thin, side-emitting light emitting devices that do not emit light through the top surface.

### SUMMARY OF THE INVENTION

It is an object of the present invention to at least partly overcome this problem, and to provide a side-emitting device that easily can be manufactured having a low thickness, while not emitting light through the top surface.

Hence, the present invention provides a side-emitting light emitting device in accordance with the appended claim 1, i.e. comprising at least one light emitting diode arranged on a substrate and facing a scattering reflector disposed at a distance from and extending along the extension of said substrate, and a solid transmissive material arranged between said substrate and said reflector, wherein the solid transmissive material is arranged such that light emitted by the light emitting diode propagates within the solid transmissive material, and wherein said reflector comprises a scattering layer facing the substrate and a reflecting layer arranged on said scattering layer, said scattering layer exhibiting a roughened surface facing said substrate and a refractive index which is different from the refractive index of said solid transmissive material. The scattering reflector comprises an essentially opaque specular reflecting component layer and a scattering component layer, such that light incident thereon from any angle of incidence is reflected and scattered.

Light emitted by the LED is incident on the scattering reflector, and independent on the angle of incidence it will be scattered and reflected. Since the scattering reflector, i.e. the specular reflecting component layer, is essentially opaque, no substantial amount of light will exit the device through the reflector and hence, all light exiting the device must do so at the opening between the substrate and the reflector. Further, since the reflector is essentially opaque, the scattering component layer of the reflector can be made just thick enough to achieve the desired scattering action. The scattering action gives rise to an angular redistribution in the device, which increases the chance of light exiting the device at all. Hence, a scattering reflector will increase the light extraction over a specular reflector.

The scattering reflector comprises a scattering layer facing the substrate and a reflecting layer arranged on said scattering layer, said scattering layer exhibiting a roughened surface facing said substrate, and has a refractive index which is different from the refractive index of said solid transmissive material. The scattering layer may be of a transparent material. The solid transmissive material between the substrate and the reflector results in a more efficient light extraction from the LED as less light is reflected from the high refractive index LED material to a higher index solid layer than to, for example, air. In addition, the critical angle of total internal reflection at the interface of the LED is increased by a solid body, increasing the light extraction from the LED.

The roughness Ra of the roughened surface is typically in the range from 1 nm to 1000 nm. Since, in accordance with the present invention, the reflecting layer is arranged on top of the scattering layer, the light encountering the reflector will pass through the scattering layer twice. By this, the thickness of the scattering layer can be drastically reduced in comparison to a scattering layer without the reflector on top in obtaining the same degree of scattering. This helps to reduce the total thickness of the device.

A roughened surface generally already exists from e.g. grinding the solid transmissive body to desired thickness. After this, the specular reflecting component layer merely has to be glued onto the scattering layer, the glue functioning as the scattering layer. Preferred embodiments of the present invention are defined in accordance with the appended dependent claims 2-6. In some preferred embodiments, the scattering layer may have a refractive index lower than the refractive index of said solid transmissive material.

When light having a certain angular distribution passes an interface from high to low refractive index, the angular distribution is increased in the low refractive index material. Hence, a good scattering action is performed upon this passage. When the reflected light returns back into the high refractive index material, it has become significantly more diffuse.

In embodiments of the present invention, the solid transmissive material may comprise a wavelength converting material.

When a wavelength converting material is arranged between the substrate and the reflector, the light emitted by the LED will be subject to wavelength conversion, and the color of the light output can be tailored to the need of the user, without increasing the size of the device or adding external elements to the device. In addition, the wavelength converting material may have a scattering effect on the light, increasing the advantages of scattering in the device.

In embodiments of the present invention, the reflector may be arranged essentially parallel to the substrate. Due to the scattering effects of the scattering reflector, the reflector can be arranged parallel to the substrate to give a thin device while having a large portion of the light emitted to exit the device through the openings between the substrate and the reflector.

### BRIEF DESCRIPTION OF THE DRAWINGS

This and other aspects of the present invention will now be described in more detail with reference to the appended drawing showing a currently preferred embodiment of the invention.

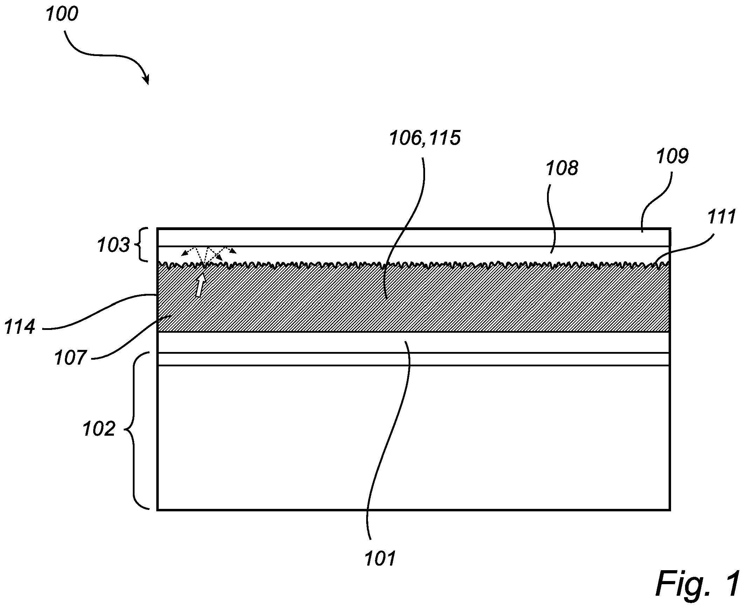

Figure 1 illustrates schematically in cross-sectional view, one embodiment of a device of the present invention.

### DETAILED DESCRIPTION

A first embodiment of a side-emitting light emitting device 100 of the present invention is schematically illustrated in figure 1 and comprises a light emitting diode, herein also denoted "LED" 101 and a substrate 102 on which the LED 101 is arranged. Not shown in this drawing, but also present in the device as conventional in the art is driving circuitry for the LED. A scattering reflector 103 is arranged above the surface of the substrate 102 on which the LED 101 is arranged. Hence, the LED 101 faces the reflector 103.

In this embodiment, the substrate 102 and the reflector 103 are illustrated as being essentially parallel, but as will follow from the description below, this is not necessary for all embodiments of the invention.

The substrate 102 and the reflector 103 form a lower and upper limit, respectively, for a light propagation region 115 disposed there between. The light propagation region 115 is filled with a solid transmissive material 106 for the light emitted by the LED 101 to propagate within.

The device has at least one lateral opening 114 at least one lateral edge of the light propagation region 115, and between the substrate and the reflector, opening(s) through which light emitted by the LED 101 and propagating in the light propagation region 115, filled with the solid transmissive material 106, may exit the device 100.

The light emitting diode 101 is arranged on the substrate 102. The light from the LED 101 typically has a substantial angular spread, such as emission in a half sphere pattern or lower spread, and has typically a main direction of light emission which is perpendicular from the surface of the substrate, a so-called top emissive LED. However, other types of LEDs may also be used in the side-emitting device of the present invention.

As used in this application, the term "light emitting diode" herein abbreviated "LED" refers to any type of light emitting diode known to those skilled in the art, including, but not limited to inorganic based LEDs, small organic molecule based LEDs (smOLEDs) and polymeric based LEDs (polyLEDs). In addition, photonic bandgap LEDs may also be used, which emits light in a narrower and tunable light cone. The light emitted by an LED suitable for use in the present invention is typically within the wavelength range of from UV light to visible light. For visible light, the emission may be of any color, from violet to red. Typically, blue light emitting LEDs are used in devices of the present invention.

The substrate 102 is a support for the LED 101 and may be of a multi layer structure. Typically, the substrate 102 comprises a layer that is reflective to the light emitted by the LED. The reflective layer may be a reflective backplane of the LED 101, which combines an electrode function with the reflective function, or may be a separate layer. The reflective layer typically comprises a metal, such as Ag or Al. According to the general scope of the invention, the scattering reflector 103 is essentially opaque. Further, it reflects and scatters light incident on the reflector, essentially no matter what angle of incidence the light has on the reflector.

Light emitted by the LED 101 is emitted having at least a component of the light directed towards the reflector 103, and upon encountering the reflector, the light is reflected back into the light propagation region, however, after this reflection being scattered, i.e. having a significantly higher angular spread, and having a significant deviation of light propagation from the incident light direction. Typically the angular spread after reflection in the reflector 103 is close to a half sphere spread. Due to this high spread, there is a good chance that light eventually will exit the device through the lateral openings 114. Scattering redistribution could also occur in the waveguiding layer of solid transmissive material 106, for example by having some scattering particles therein.

The degree of reflection in the reflection is typically in the range of R > about 80%, such as R > about 90%.

To obtain these highly reflective and scattering properties of the scattering reflector, it comprises an essentially opaque specular reflecting component layer and one scattering component layer. Light from any angle of incidence on the reflector is scattered and reflected due to the fact that the light is scattered before or simultaneously as it is being reflected. Since the specular reflecting component layer is opaque, essentially no light escapes out from the device through the top surface. In addition, since the specular reflecting component layer is opaque, the scattering component layer can be held to a minimum, just having enough of it to provide the desired scattering. The scattering component layer can also contribute to the reflection by backscattering. The scattering reflector may comprise several layers including substrates used in the production of the reflector.

The reflector 103 in the embodiment of the present invention in figure 1 will be described more in detail below.

The LED 101 emits light into the region between the substrate 102 and the reflector 103. This region is herein denoted as the light propagation region 115. A purpose of this light propagation region 115 is to lead the light from the LED 101 to the lateral openings 114. In this light propagation region, light is reflected back and forth between the reflective surfaces and will eventually exit the device through the lateral openings 114.

The light propagation region is preferably essentially transparent to light of the wavelengths emitted by the LED(s) of the device, such as not to absorb light in an appreciable extent.

The light propagation region 115 is filled with the solid transmissive material 106. Examples of solid transmissive materials suitable for use in a solid body light propagation region 106, 115 include, but are not limited to solid inorganic materials, such as alumina, glass, fused silica, sapphire, and YAG, and silicones, fluoropolymers, polyolefiens or other polymers. The solid body light propagation region 106, 115 may further comprise an additional amount of scattering material to obtain a homogenous light distribution in the region. In embodiments of the present invention, the solid body light propagation region 106, 115 may, but does not necessarily, comprise wavelength converting material 107 arranged, such as distributed in the light propagation region 115, or may be formed from a wavelength converting material. Hence, a significant portion of the light exiting the light propagation region 115 will have been subject to the wavelength converting material 107.

The wavelength converting material 107 is a material which upon absorption of light of a certain wavelength or wavelength range, emits light of a different, converted, wavelength or wavelength range. Typically, the converted wavelengths are shifted towards longer wavelengths. Conventionally, such materials are typically fluorescent and/or phosphorescent. Many such wavelength converting materials are known to those skilled in the art, and one commonly used group of compound goes under the name "phosphors".

The wavelength converting material may for example be ceramic, solid materials or embedded in a binder material, such as a carrier polymer.

The wavelength converting material 107 is matched to the LED 101 such that it absorbs at least part of the light emitted by the LED. Hence, the selection of wavelength converting material depends on the selection of LED. For example, the wavelength converting material may partly convert blue light into green/yellow light, which mixes into white light. However, other wavelength converting materials may be used as well, for example fully converting blue into green, yellow or red, or converting UV-light into visible light.

In the present invention, the light propagation region 115 comprises the solid transmissive material 106, as is described above, optionally comprising a wavelength converting material.

The reflector 103 comprises a scattering layer 108 facing the solid material light propagation region 106, 115 and a reflective surface layer 109 arranged on the scattering layer. In this embodiment, the scattering layer 108 has a roughened surface 111 facing the solid material light propagation region 106, 115 and the refractive index of the scattering layer 108 is lower than the refractive index of the solid material light propagation region 106, 115. Examples of such low index materials include, but are not limited to xerogels, aerogels, fluoropolymers, silicones, silicates, nano-porous silicates and low index sol-gel materials. The low index material may function as glue, bonding the reflector to the light propagation region. Typically, a solid light propagation region has a refractive index of 1.8 to 2.1 or higher, and hence a low index material with a refractive index of lower than about 1.5 is preferred. In an alternative embodiment, the refractive index of the scattering layer is higher than the refractive index of the solid material light propagation region.

The roughened surface 111 exhibits such roughness that light passing this surface is scattered to a significant extent. The scattered light will thereafter be reflected on the reflective surface layer 109 and will then once again pass the scattering layer before entering the solid material light propagation region 106, 115 for transmission towards the lateral exit openings 114.

In the device of the present invention, a typical LED die size is about 1x1 mm, but also smaller or larger dimensions may be used. The typical thickness of the light propagation region is in the range of from about 10 µm to a few mm, such as from 10 µm to 2 mm, such as in the range of from 50 to 500 µm, typically about 300 µm.

The person skilled in the art realizes that the present invention by no means is limited to the preferred embodiments described above. On the contrary, many modifications and variations are possible within the scope of the appended claims. For example, in the drawings, the substrate and the reflector are illustrated as having their lateral edges coinciding with the lateral edges of the solid material light propagation region. However, it is also possible that the lateral edges of at least one of the substrate and the reflector is outside of the solid material light propagation region. To summarize, a side-emitting light emitting device in accordance with the present invention is provided, comprising at least one light emitting diode arranged on a substrate and facing a scattering reflector disposed at a distance from and extending along the extension of said substrate, and a solid transmissive material arranged between said substrate and said reflector, wherein the solid transmissive material is arranged such that light emitted by the light emitting diode propagates within the solid transmissive material. The reflector comprises a scattering layer facing the substrate and a reflecting layer arranged on said scattering layer, said scattering layer exhibiting a roughened surface facing said substrate and a refractive index which is different from the refractive index of said solid transmissive material.

The scattering action of the reflector gives rise to an angular redistribution in the device, which increases the chance of light exiting the device through lateral openings between the reflector and the substrate, while the opacity prevents light from being emitted through the top surface. The light emitting device of the present invention may for example be used within the areas of LED-illumination, for example for backlight application in display devices, in light guide applications, including flat light guide luminaries, LED collimator configurations, such as can be used for automotive headlighting or general LED-spot lighting. The areas of use are however not limited to the above.

## Claims

1. A side-emitting light emitting device (100), comprising at least one light emitting diode (101) arranged on a substrate (102) and facing a scattering reflector (103) disposed at a distance from and extending along the extension of said substrate (102), and a solid transmissive material (106) arranged between said substrate (102) and said reflector (103), wherein the solid transmissive material (106) is arranged such that light emitted by the light emitting diode (101) propagates (115) within the solid transmissive material (106), and wherein said reflector (103) comprises a scattering layer (108) facing the substrate (102) and a reflecting layer (109) arranged on said scattering layer (108), said scattering layer (108) exhibiting a roughened surface (111) facing said substrate (102) and a refractive index which is different from the refractive index of said solid transmissive material (106).

2. The light emitting device (100) according to claim 1, wherein said scattering layer (108) has a refractive index lower than the refractive index of said solid transmissive material (106).

3. The light emitting device (100) according to claim 1, wherein said scattering layer (108) has a refractive index higher than the refractive index of said solid transmissive material (106).

4. The light emitting device (100) according to any of the preceding claims, wherein said solid transmissive material (106) comprises a wavelength converting material (107).

5. The light emitting device (100) according to any of the preceding claims, wherein said reflecting layer (109) comprises a specular surface facing said scattering layer (108).

6. The light emitting device (100) according to any of the preceding claims, wherein said reflector (103) is arranged parallel to said substrate (102).

## Patentansprüche

1. Seitlich emittierende Licht emittierende Vorrichtung (100), umfassend mindestens eine Leuchtdiode (101), die auf einem Substrat (102) angeordnet ist und einem Streureflektor (103) gegenüber liegt, der sich in einem Abstand von der Ausdehnung des Substrats (102) befindet und sich von diesem ausdehnt, und ein festes durchlässiges Material (106), das zwischen dem Substrat (102) und dem Reflektor (103) angeordnet ist, wobei das feste durchlässige Material (106) derart angeordnet ist, dass sich das Licht, das von der Leuchtdiode (101) emittiert wird, innerhalb des durchlässigen Materials (106) verbreitet (115), und wobei der Reflektor (103) eine Streuschicht (108) umfasst, die dem Substrat (102) gegenüber liegt, und eine reflektierende Schicht (109), die auf der Streuschicht (108) angeordnet ist, wobei die Streuschicht (108) eine aufgeraute Oberfläche (111) aufweist, die dem Substrat (102) gegenüber liegt, und einen Brechungsindex, der verschieden vom Brechungsindex des festen durchlässigen Materials (106) ist.

2. Licht emittierende Vorrichtung (100) nach Anspruch 1, wobei die Streuschicht (108) einen Brechungsindex aufweist, der niedriger als der Brechungsindex des festen durchlässigen Materials (106) ist.

3. Licht emittierende Vorrichtung (100) nach Anspruch 1, wobei die Streuschicht (108) einen Brechungsindex aufweist, der höher als der Brechungsindex des festen durchlässigen Materials (106) ist.

4. Licht emittierende Vorrichtung (100) nach einem der vorhergehenden Ansprüche, wobei das feste durchlässige Material (106) ein wellenlängenkonvertierendes Material (107) umfasst.

5. Licht emittierende Vorrichtung (100) nach einem der vorhergehenden Ansprüche, wobei die reflektierende Schicht (109) eine spiegelnde Oberfläche umfasst, die der Streuschicht (108) gegenüber liegt.

6. Licht emittierende Vorrichtung (100) nach einem der vorhergehenden Ansprüche, wobei der Reflektor (103) parallel zu dem Substrat (102) angeordnet ist.

## Revendications

1. Dispositif d'émission de lumière à émission latérale (100), comprenant au moins une diode électroluminescente (101) agencée sur un substrat (102) et faisant face à un réflecteur de dispersion (103) disposé à distance de l'extension dudit substrat (102) et s'étendant le long de celle-ci, et un matériau transmissif solide (106) agencé entre ledit substrat (102) et ledit réflecteur (103), dans lequel le matériau transmissif solide (106) est agencé de sorte que la lumière émise par la diode électroluminescente (101) se propage (115) dans le matériau transmissif solide (106), et dans lequel ledit réflecteur (103) comprend une couche de dispersion (108) faisant face au substrat (102) et une couche de réflexion (109) agencée sur ladite couche de dispersion (108), ladite couche de dispersion (108) présentant une surface rugueuse (111) faisant face audit substrat (102) et un indice de réfraction qui est différent de l'indice de réfraction dudit matériau transmissif solide (106).

2. Dispositif d'émission de lumière (100) selon la revendication 1, dans lequel ladite couche de dispersion (108) a un indice de réfraction inférieur à l'indice de réfraction dudit matériau transmissif solide (106).

3. Dispositif d'émission de lumière (100) selon la revendication 1, dans lequel ladite couche de dispersion (108) a un indice de réfraction supérieur à l'indice de réfraction dudit matériau transmissif solide (106).

4. Dispositif d'émission de lumière (100) selon l'une quelconque des revendications précédentes, dans lequel ledit matériau transmissif solide (106) comprend un matériau de conversion de longueur d'onde (107).

5. Dispositif d'émission de lumière (100) selon l'une quelconque des revendications précédentes, dans lequel ladite couche de réflexion (109) comprend une surface spéculaire faisant face à ladite couche de dispersion (108).

6. Dispositif d'émission de lumière (100) selon l'une quelconque des revendications précédentes, dans lequel ledit réflecteur (103) est arrangé en parallèle audit substrat (102).
